# EUROPEAN PATENT APPLICATION

(11) **EP 4 783 239 A1**
(43) Date of publication of application: **29.07.2026**
(21) Application number: 24881053.3
(22) Date of filing: 18.06.2024
(51) Int. Cl.: H01L 23/498

(54) **CHIP PACKAGING SYSTEM AND ELECTRONIC DEVICE**

(30) Priority: 24.10.2023 CN 202311391834
(71) Applicant: HUAWEI TECHNOLOGIES CO., LTD., Shenzhen 518129 (CN)
(72) Inventor: LIANG, Ying, Shenzhen, Guangdong 518129 (CN); XIE, Zhenlin, Shenzhen, Guangdong 518129 (CN); GAO, Feng, Shenzhen, Guangdong 518129 (CN); YU, Chaowei, Shenzhen, Guangdong 518129 (CN)
(74) Representative: Pfenning, Meinig & Partner mbB
(86) International application number: PCT/CN2024/099947
(87) International publication number: WO 2025/086676

(57) **Abstract**

A chip packaging system and an electronic device are provided. The chip packaging system includes a PCB, a local interconnection component, and a plurality of dies, where the local interconnection component is disposed on a board of the PCB, and the dies are electrically interconnected with the PCB separately; and the local interconnection component includes a dielectric layer and a high-density interconnection line layer that are stacked, and at least two dies are electrically interconnected through the local high-density interconnection circuit. In this way, the dies and the local interconnection component are mounted on the PCB to form a chip on board system, which effectively improves mountability, reliability, and availability of the system while meeting a high-density layout requirement. Similarly, based on a structural feature that the dies are mounted on the board surface of the PCB by using the local interconnection component, a link loss caused by conventional packaging and system costs can be reduced.

## Description

This application claims priority to Chinese Patent Application No. 202311391834.5, filed with the China National Intellectual Property Administration on October 24, 2023 and entitled "CHIP PACKAGING SYSTEM AND ELECTRONIC DEVICE", which is incorporated herein by reference in its entirety.

### TECHNICAL FIELD

Embodiments of this application relate to the field of chip packaging technologies, and in particular, to a chip packaging system and an electronic device.

### BACKGROUND

With increasing difficulty in transistor process scaling and increasing requirements for high performance of chips, the industry has begun to explore solutions in the packaging field. In a conventional chip on board system, a chip package is formed by packaging a die (die) on a substrate and then mounted on a printed circuit board (Printed Circuit Board, PCB). A flip chip ball grid array (Flip chip BGA, FCBGA) packaging technology has been widely used because of high integration, high performance, and low power consumption of the technology.

To meet a high-density layout requirement, in a typical FCBGA packaging architecture, a silicon interposer (interposer) based on a re-distributed layer (Re-distributed layer, RDL) is disposed between a die and a substrate, to implement small-spacing placement of dies, thereby effectively improving bandwidth performance. With integration of more chips, an FCBGA size becomes increasingly large, leading to development bottlenecks in aspects of mountability, reliability, and availability.

### SUMMARY

Embodiments of this application provide a locally high-density chip packaging system and an electronic device, to effectively improve mountability, reliability, and availability of a system while meeting a high-density layout requirement.

A first aspect of the embodiments of this application provides a chip packaging system. The chip packaging system includes a PCB, a local interconnection component, and a plurality of dies. The local interconnection component and the plurality of dies are disposed on the PCB, and the plurality of dies are electrically interconnected with the PCB separately; and the local interconnection component includes a dielectric layer and a high-density interconnection line layer that are stacked, and at least two dies are electrically interconnected through the local interconnection component.

In this way, the dies are mounted on the PCB, and electrical interconnection between the dies is implemented by using the local interconnection component, to form a chip on board system. In specific implementation, the local interconnection component may be detected as a monolithic unit, and is integrated with and mounted on the PCB while it is ensured that functions of the local interconnection component are intact. In addition, as a monolithic unit, the local interconnection component is small in size and has relatively good mountability, so that a manufacturing yield of a chip system is ensured, thereby reducing manufacturing costs.

In addition, a size of electrical interconnection between the PCB and each of the dies and the local interconnection component is relatively small. Under same power consumption, the solution can effectively reduce a possibility of heat deformation in an interconnection area, so that a serving time of the system is properly prolonged and the system has relatively high reliability.

In addition, high-density layout of a relatively large quantity of dies may be implemented according to a function requirement, and construction of the chip packaging system is not affected by difficulty in implementing a large-sized substrate, and the chip packaging system has relatively good availability.

For example, one or more local interconnection components may be disposed. In an actual application, when a plurality of local interconnection components are disposed on a board surface on a side of the PCB, the plurality of local interconnection components may be disposed on the board surface of the PCB at intervals.

Based on the first aspect, the embodiments of this application further provide a first implementation of the first aspect: The PCB further includes a buildup layer, the buildup layer is disposed on a periphery of a local interconnection component, and interface pads electrically interconnected with the dies are disposed on a surface of the buildup layer. In an actual application, a material of the buildup layer may be provided with a window that can accommodate the local interconnection component, a blind via for external interconnection, and the like, and the interface pads for the dies and the local interconnection component are provided on a surface of the buildup layer, so that the dies keep a stable posture in an assembly process.

For example, the material of the buildup layer may be an organic material, for example, an ajinomoto build-up film (Ajinomoto Build-up Film, ABF) dielectric material.

Based on the first implementation of the first aspect, the embodiments of this application further provide a second implementation of the first aspect: The local interconnection component includes a first surface and a second surface, where the first surface of the local interconnection component is disposed opposite to the PCB, and the second surface of the local interconnection component is disposed opposite to the dies. The interface pads located on the surface of the buildup layer include a first pad and a second pad, where the first pad is electrically connected to a pin on the first surface of the local interconnection component, and the second pad is electrically connected to a die interface pad on a surface layer of the PCB. This arrangement has characteristics of a simple structure and good manufacturability while effectively improving operability of assembling dies on the board.

In an actual application, structural forms and board surface layout forms of the first pad and the second pad may be determined based on external interface forms of the local interconnection component and the dies.

Based on the first implementation of the first aspect or the second implementation of the first aspect, the embodiments of this application further provide a third implementation of the first aspect: The interface pads on the surface of the buildup layer include the first pad and the second pad, and may be electrically connected to the local interconnection component and the PCB separately through a stacked via on the buildup layer. Based on a structural feature that the local interconnection component is directly disposed on the board surface of the PCB, a thickness of the buildup layer only needs to meet a forming condition of the first pad corresponding to the local interconnection component. In this way, the thickness of the buildup layer is properly controlled, and a layer of stacked vias may be disposed on the buildup layer to implement electrical connection between the dies and the local interconnection component, thereby achieving better manufacturability.

Based on the first aspect, the embodiments of this application further provide a fourth implementation of the first aspect: The PCB further includes a pillar, the pillar is disposed on the PCB on a side of the local interconnection component, the pillar extends towards the dies connected to the local interconnection component, and an end face of the pillar is connected to the dies. In this way, mechanical support and external electrical interconnection are provided by disposing the pillar, thereby improving reliability of die assembly.

Based on the fourth implementation of the first aspect, the embodiments of this application further provide a fifth implementation of the first aspect: The local interconnection component includes a first surface and a second surface, where the first surface of the local interconnection component is disposed opposite to the PCB, and the second surface of the local interconnection component is disposed opposite to the dies. The end face of the pillar configured to be connected to the dies is flush with an interconnection pad on the first surface of the local interconnection component. In this way, based on the pillar, a height difference between pads connected to pins of the dies can be leveled, so that mounting areas of the dies are approximately on one plane, thereby further improving the reliability of the die assembly.

Based on the fourth implementation of the first aspect or the fifth implementation of the first aspect, the embodiments of this application further provide a sixth implementation of the first aspect: The pillar is a conductive pillar, and the pillar is electrically connected to a die interface pad on the PCB, to establish electrical interconnection between the dies connected to the local interconnection component and the PCB. In other words, the pillar may be a conductive pillar configured on a pad on the surface of the PCB. In this way, in addition to auxiliary mechanical support, an electrical connection function is also provided.

In an actual application, a conductive pillar may be made of a metal material. For example, the pillar may be a copper pillar electrically connected to a die interface pad on the PCB, and has relatively good conductivity, may quickly export heat on a board side based on a good heat conduction capability of the copper pillar, and therefore also have a heat dissipation function. In this way, during assembling of the dies on the board, two dies to be connected are welded to the interconnection pad on the first surface of the local interconnection component, and electrical interconnection is implemented through the high-density interconnection line layer of the local interconnection component. The dies are also welded to the conductive pillar, to implement electrical interconnection between the dies and the PCB. Overall, system integration can be further improved.

For another example, the conductive pillar is alternatively made of a non-metal material, and a surface of the pillar is plated with copper, so that the conductive pillar may also have both a support function and an electrical connection function.

Based on the sixth implementation of the first aspect, the embodiments of this application further provide a seventh implementation of the first aspect: The local interconnection component and the pillar are packaged in plastic to form a plastic package body located on the board surface of the PCB, and the end face of the pillar and the interconnection pad on the first surface of the local interconnection component are exposed from a surface of the plastic package body. In this way, the plastic package body is formed in a local position area on the board surface of the PCB, which can further improve the reliability of the die assembly and reduce process implementation costs.

For example, an EMC material may be used for plastic packaging. In an actual application, a plastic package material covering the top of the local interconnection component and the pillar may be removed, for example, through a grinding process, so that the conductive pillar and the interconnection pad of the local interconnection component are exposed from the plastic package body, to establish reliable electrical connection.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, the embodiments of this application further provide an eighth implementation of the first aspect: The local interconnection component is a double-sided interconnection structure, and a pin on the second surface of the local interconnection component is electrically connected to an interconnection component interface pad on the board surface of the PCB. In an actual application, the double-sided local interconnection component can be flexibly configured based on a system function design.

For example, after a flux cleaning operation is performed, an underfill process may be used to protect a solder joint between the local interconnection component and the PCB, and then the dies are assembled. In addition, for example, when a conductive pillar is disposed, flux cleaning may also be performed as a whole after all dies are assembled, and an underfill process is used to protect a solder joint between the local interconnection component and the PCB and a solder joint between the dies and the PCB. Based on a structural feature that the local interconnection component is directly disposed on the board surface of the PCB, it is convenient to perform cleaning and underfill operations, and mountability and reliability of the local interconnection component being interconnected downward can be effectively ensured.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, or the eighth implementation of the first aspect, the embodiments of this application further provide a ninth implementation of the first aspect: The local interconnection component is a single-sided interconnection structure, and the second surface of the local interconnection component is glued and fastened to the board surface of the PCB. The single-sided local interconnection component can be flexibly configured based on a system function design, and this is easy to implement through a process.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, or the eighth implementation of the first aspect, or the ninth implementation of the first aspect, the embodiments of this application further provide a tenth implementation of the first aspect: The dielectric layer may be made of an organic material or an inorganic material.

In an actual application, for a local interconnection component whose dielectric layer is made of an organic material, a material of the dielectric layer of the local interconnection component has a similar thermal expansion capability to a base material of the PCB, to avoid mechanical stress caused by deformation of the dielectric layer and the PCB at a joint after being heated. Correspondingly, the substrate of the PCB may be a BT plate, and the dielectric layer 21 may be made of polyimide (polyimide, PI), polypropylene (polypropylene, PP), or ABF.

In another actual application, for a local interconnection component whose dielectric layer uses an inorganic material, correspondingly, the substrate of the PCB may be a ceramic sheet, a glass sheet, or a metal plate, and the dielectric layer may be made of SiO₂.

Based on the first aspect, or the first implementation of the first aspect, or the second implementation of the first aspect, or the third implementation of the first aspect, or the fourth implementation of the first aspect, or the fifth implementation of the first aspect, or the sixth implementation of the first aspect, or the seventh implementation of the first aspect, or the eighth implementation of the first aspect, or the ninth implementation of the first aspect, or the tenth implementation of the first aspect, the embodiments of this application further provide an eleventh implementation of the first aspect: The chip packaging system further includes another functional device disposed on the PCB. In an actual application, the another functional device disposed on the PCB may include at least one of a power supply module, a connector, and a capacitor.

Based on the eleventh implementation of the first aspect, the embodiments of this application further provide a twelfth implementation of the first aspect: The another functional device and the dies are located on a same side board surface of the PCB, or the another functional device is located on the board surface that is of the PCB and that is opposite to the dies.

For example, for the power supply module, the dies are located on a side board surface of the PCB, and the power supply module is located on another side board surface of the PCB, and is located on the board surface that is of the PCB and that is opposite to the dies. Therefore, a vertical power supply board-level architecture with a relatively low power supply loss and relatively high integration is formed. For another example, the power supply module may alternatively be located on a same side board surface of the PCB as the dies, to form a horizontal power supply board-level architecture.

In addition, for example, for the connector, the connector and the dies may be located on a same side board surface, so that a link length is properly controlled, and a link loss between the connector and the dies may be reduced.

A second aspect of the embodiments of this application provides an electronic device. The electronic device includes a mainboard and the foregoing chip packaging system, and the chip packaging system is disposed on the mainboard. For example, the chip packaging system may be a functional component such as a CPU, a GPU, an ASIC, or an SOC configured in the electronic device.

In an actual application, the electronic device may be a server, a computer, or a high-performance computing cluster. In addition, the electronic device may be a switch, a router, a building baseband unit, an edge device, or the like.

### BRIEF DESCRIPTION OF DRAWINGS

FIG. 1 is a diagram of an architecture of a chip on board system according to an embodiment of this application;
FIG. 2 is a diagram of an assembly relationship between a local interconnection component shown in FIG. 1 and a PCB;
FIG. 3 is a diagram of a structure of a local interconnection component according to an embodiment of this application;
FIG. 4 is a diagram of a structure of another local interconnection component according to an embodiment of this application;
FIG. 5 is a schematic flowchart of assembling a local interconnection component shown in FIG. 1;
FIG. 6 is a diagram of another assembly relationship between a local interconnection component and a PCB according to an embodiment of this application;
FIG. 7 is a schematic flowchart of assembling a local interconnection component shown in FIG. 6; and
FIG. 8 is a diagram of a structure of an electronic device according to an embodiment of this application.

### DESCRIPTION OF EMBODIMENTS

Embodiments of this application provide an implementation solution of a chip on board system architecture, to effectively meet a high-density layout requirement while improving mountability, reliability, and availability.

In high-density layout and high-integration scenarios, flip chips (flip chips) are used in medium- and high-performance products. A typical FCBGA packaging architecture is used as an example. A line width capability of a substrate is usually about 15 µm. To improve architecture layout density, a silicon interposer layer is disposed between a die and the substrate in the architecture. A line width capability of an RDL fabricated on a silicon chip may reach 1 µm, which is far less than a line width of an RDL fabricated on a resin substrate, so that dies can be placed at a small spacing. An FCBGA package is mounted on the PCB board to form a chip on board system that can meet specified functions. With improvement of product performance, a quantity of dies integrated in the FCBGA packaging architecture increases accordingly, and consequently, an FCBGA size increases accordingly, and a development bottleneck occurs in aspects such as mountability, reliability, and availability.

Based on this, an embodiment of this application provides a chip on board system, including a PCB, a local interconnection component, and a plurality of dies. The local interconnection component and the plurality of dies are disposed on the PCB, and the plurality of dies are electrically interconnected with the PCB separately. The local interconnection component includes the dielectric layer and the high-density interconnection line layer disposed in the dielectric layer that are stacked, and the at least two dies are electrically interconnected through the high-density interconnection line layer of the local interconnection component. In this way, the dies are directly mounted on the PCB, and electrical interconnection between the dies is implemented by using the local interconnection component, to form a chip on board system. Both the dies and the local interconnection component have a mounting relationship with the PCB, and a monolithic unit size is relatively small. Compared with an FCBGA packaging architecture and a manner of implementing chip assembly on a PCB, this solution can effectively reduce mounting difficulty caused by warping of a large-sized FCBGA, and has relatively good mountability, so that a manufacturing yield of a chip system is ensured, thereby reducing manufacturing costs. At the same time, a size of electrical interconnection between the PCB and each of the dies and the local interconnection component is relatively small. Under same power consumption, the solution can effectively reduce a possibility of heat deformation in an interconnection area, and the system has relatively high reliability.

In addition, based on a structural feature that the dies are directly mounted on the board surface of the PCB through the local interconnection component, reduction of a link loss and costs caused by packaging can be avoided. In an actual application, high-density layout of a relatively large quantity of dies may be implemented according to a function requirement, and this is not affected by difficulty in implementing a large-sized substrate, and has relatively good availability. In addition, the local interconnection component is mounted on the board surface of the PCB, so that a coupling process between the local interconnection component and the PCB is implemented, and mountability may be further improved.

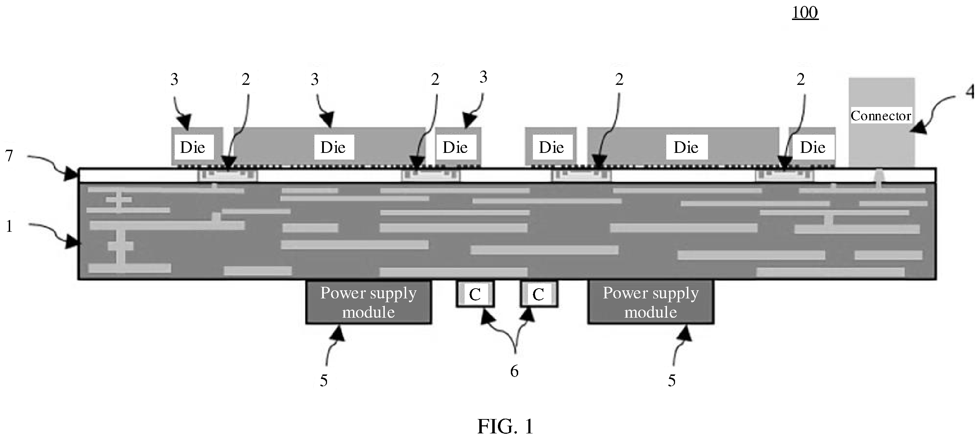

To better understand the technical solutions and technical effects of this application, without loss of generality, the following describes specific embodiments in detail with reference to the accompanying drawings. FIG. 1 is a diagram of an architecture of a chip on board system according to an embodiment of this application.

As shown in FIG. 1, a local interconnection component 2, a plurality of dies 3, a connector 4, and a power supply module 5 are disposed on a PCB 1 of the chip on board system 100. The dies 3 may be electrically interconnected with the PCB 1 and, for example, but not limited to, may be separately configured to implement power supply, communication (data signal and/or control signal) transmission, and the like. In this implementation solution, the dies 3 are located on a side board surface of the PCB 1, and the power supply module 5 is located on another side board surface of the PCB 1, so that a vertical power supply board-level architecture with a relatively low power supply loss and relatively high integration is formed. In another possible implementation solution, the power supply module 5 may alternatively be located on a same side board surface of the PCB 1 as the dies 3, to form a horizontal power supply board-level architecture.

For example, in this implementation solution, at least four local interconnection components 2 are disposed on a side board surface of the PCB 1, two adjacent dies 3 may be coupled to the PCB 1 through the local interconnection components 2, and electrical interconnection between the two adjacent dies 3 is implemented based on the local interconnection components 2, for example, but not limited to, for high-performance data transmission between the dies. It should be understood that, in another possible implementation solution, a quantity of disposed local interconnection components 2 may be determined according to a system function requirement. For example, one or more other local interconnection components may be disposed. When a plurality of local interconnection components are disposed on the side board surface of the PCB 1, the local interconnection components may be arranged at intervals. In addition, for a plurality of dies on the board, some dies may be electrically interconnected based on the local interconnection components 2, and the other dies may be directly electrically connected to the PCB 1. This may be specifically determined based on an overall product design. This is not limited in the embodiments of this application.

A local interconnection component 2 is disposed on the board surface of the PCB 1, and a structure of the local interconnection component 2 may be a structure in which a dielectric layer and a re-distributed layer are mixed, that is, a high-density interconnection line layer is constructed by using the re-distributed layer. For example, but not limited to, the local interconnection component 2 may be a structure formed by alternately stacking a dielectric layer and a metal layer (such as copper). The local interconnection component 2 may be used to implement electrical interconnection between two adjacent dies 3, and also implement electrical interconnection between two adjacent dies 3 in a group of dies.

The connector 4, the local interconnection component 2, and the plurality of dies 3 are located on a same side board surface of the PCB 1, and are configured to be connected to other external components (not shown in the figure). The connector 4 and the dies 3 are located on a same side board surface, so that a link length is properly controlled, and a link loss between the connector and the dies may be reduced. A structure form and a quantity of disposed connectors 4 mounted on the PCB 1 may be configured based on a function of the board system, to implement electrical interconnection between an external component and a PCB 1 side, and meet a requirement of electrical interaction.

In addition, as an optional configuration structure, the connector 4 may alternatively be located on another side board surface that is of the PCB 1 and that is away from the local interconnection component 2 and the dies 3, instead of being limited to being located on the same side board surface of the PCB 1 as the local interconnection component 2 and the dies 3. This is not limited in embodiments of this application.

In addition to the power supply module 5 and the connector 4, another functional component may be further disposed on the PCB 1 of the chip on board system 100. Optionally, a passive device 6 may be further disposed on another side board surface of the PCB 1. The passive device 6 is a non-active device of the chip on board system, and may be a device such as a capacitor, a resistor, or an inductor, for example, but not limited to the capacitor shown in FIG. 1. In specific implementation, the passive device 6 may be disposed based on a circuit design of the chip on board system.

For the chip on board system architecture, the dies 3 may be dies of a same type or dies of different types, to implement different function configurations. In specific implementation, at least some of the plurality of dies 3 is a memory die, and may be determined according to an overall design requirement of a specific application scenario, to implement a data read/write operation; and may be, for example, but is not limited to an integrated circuit component such as a central processing unit (Central Processing Unit, CPU), a graphics processing unit (Graphic Processing Unit, GPU), an application-specific integrated circuit (Application-Specific Integrated Circuit, ASIC), or a system on chip (System on Chip, SOC). This is not limited in embodiments of this application.

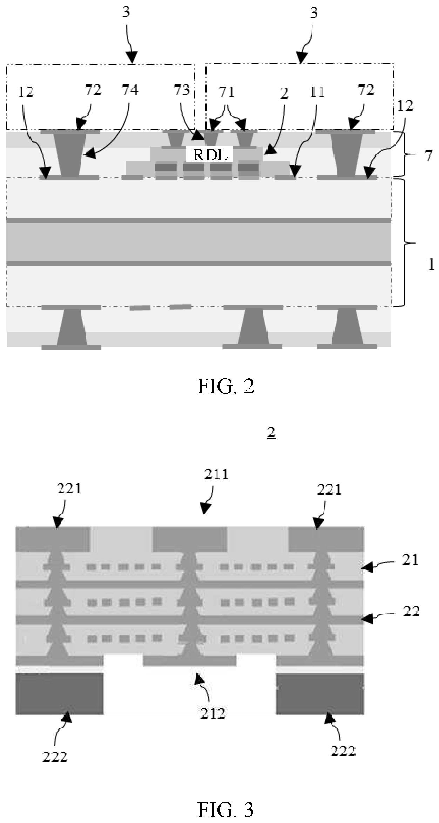

In order to improve reliability of die assembly, further, for the local interconnection component 2 disposed on the board surface of the PCB 1, the chip on board system 100 provided in this implementation solution provides basic support and external electrical interconnection through a buildup (buildup) layer 7. Refer to FIG. 1 and FIG. 2. FIG. 2 is a diagram of an assembly relationship between a local interconnection component shown in FIG. 1 and a PCB.

As shown in FIG. 2, the buildup layer 7 is disposed on a substrate of the PCB 1 on a periphery of the local interconnection component 2, and the dies 3 may be assembled and fastened through the buildup layer 7. A material of the buildup layer 7 is provided with a window that can accommodate a local interconnection component 2, a blind via for external interconnection, and the like, and the interface pads for the dies and the local interconnection component 2 and the interface pads for the dies and the PCB 1 are provided on a surface of the buildup layer 7, so that the dies 3 keep a stable posture in an assembly process.

For electrical connection between the local interconnection component 2 and the die 3, a first pad 71 electrically connected to a pin of the local interconnection component 2 may be disposed on a surface of the buildup layer 7, and the first pad 71 is interconnected with the PCB 1 side through a corresponding first blind via 73. For electrical connection between the PCB 1 and the die 3, a second pad 72 electrically connected to a die interface pad 12 on the surface layer of the PCB 1 may be disposed on the surface of the buildup layer 7, and the second pad 72 may be interconnected with the PCB 1 side through a corresponding second blind via 74. In this way, during assembling of the dies 3 on the board, the two dies 3 to be connected are welded to corresponding first pads 71 on the surface of the buildup layer 7, and electrical interconnection is implemented through the high-density interconnection line layer of the local interconnection component 2. The dies 3 are also welded to corresponding second pads 72 on the surface of the buildup layer 7, to implement electrical interconnection between the dies and the PCB.

Based on a structural feature that the local interconnection component 2 is directly disposed on the board surface of the PCB 1, a thickness of the buildup layer 7 only needs to meet a forming condition of the first pad 71 corresponding to the local interconnection component 2. In this way, the thickness of the buildup layer 7 is properly controlled, and a layer of stacked vias may be disposed in the buildup layer to implement electrical connection between the dies and the local interconnection component 2. Compared with an implementation (not shown in the figure) in which a slot is provided on a PCB, a local interconnection component is placed in the slot, and then an electrical interface is provided through a buildup layer, in this implementation, at least two layers of stacked vias are required to establish an electrical connection relationship between a die and a PCB, and only one layer of stacked vias needs to be processed on the buildup layer 7 in this solution, to achieve better manufacturability.

In a possible implementation solution, structural forms and board surface layout forms of the first pad 71 and the second pad 72 may be determined based on external interface forms of the local interconnection component 2 and the dies. This is not limited in embodiments of this application.

Optionally, as shown in FIG. 2, the local interconnection component 2 may be a vertical double-sided interconnection structure, a pin used for electrical connection to the dies 3 is located on a first surface (top surface) of the local interconnection component 2, and a pin used for electrical connection to the PCB 1 is located on a second surface (bottom surface) of the local interconnection component 2. The surface layer of the PCB 1 further includes an interconnection component interface pad 11, and the pin on the second surface of the local interconnection component 2 is welded to the interconnection component interface pad 11 to meet a system requirement.

For a double-sided interconnection local interconnection component 2, an underfill (underfill) process may be used to protect a solder joint between the pin on the second surface of the local interconnection component 2 and the interconnection component interface pad 11. Specifically, a liquid underfill material is injected or sprayed to the periphery of the local interconnection component 2, penetrates between the local interconnection component 2 and the PCB 1 by using a capillary flow principle, and is heated and cured. Based on a structural feature that the local interconnection component 2 is directly disposed on the board surface of the PCB 1, it is convenient to implement an underfill process, and technical support is provided for welding reliability of the local interconnection component 2.

In another possible implementation solution, the liquid underfill may alternatively be replaced by a non-conductive adhesive film (Non-Conductive Adhesive Film, NCF), so that a function of reliably fastening the local interconnection component 2 can also be implemented.

FIG. 3 is a diagram of a structure of a local interconnection component according to an embodiment of this application. The local interconnection component 2 shown in FIG. 3 is a double-sided interconnection structure, and the local interconnection component 2 includes a dielectric layer 21 and a high-density interconnection line layer 22 disposed in the dielectric layer 21. In specific implementation, the high-density interconnection line layer 22 may be an RDL re-distributed layer.

An interconnection pad 221 is disposed on the first surface 211 of the local interconnection component 2, and is used as a pin for electrical connection between the local interconnection component 2 and the die 3. In a scenario in which a buildup layer is needed, the interconnection pad 221 is connected to the pin of the die through the first blind via 73 and the first pad 71 shown in FIG. 2. For an implementation in which the local interconnection component 2 is connected to the PCB 1 by using a welding process, a metal bump (BUMP) 222 may be fabricated on the second surface 212 of the local interconnection component 2, and is used as a pin for electrical connection between the local interconnection component 2 and the PCB 1. Certainly, for another interconnection manner, a pin electrically connected to the PCB 1 may be fabricated by making a pad pattern.

In another possible implementation, according to a system requirement, the local interconnection component 2 may be configured only in a form of upward interconnection with the die, namely, a single-sided interconnection structure.

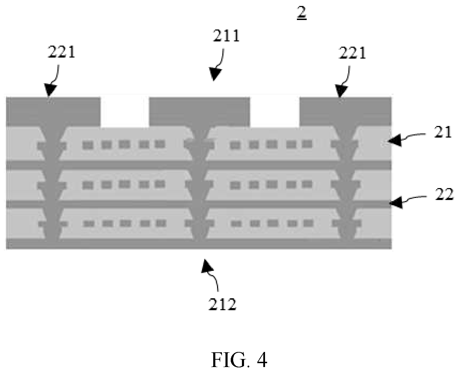

FIG. 4 is a diagram of a structure of another local interconnection component according to an embodiment of this application. The local interconnection component 2 shown in FIG. 4 is a single-sided interconnection structure. An interconnection pad 221 is disposed on the first surface 211 of the local interconnection component 2, and is used as a pin for electrical connection between the local interconnection component 2 and the die 3, and is fastened on the board surface of the PCB 1 through the second surface 212 of the local interconnection component 2. In specific implementation, the local interconnection component 2 of the single-sided interconnection structure may be fixedly disposed on the board surface of the PCB 1 by using a conventional glue bonding process.

For the dielectric layer 21 of the local interconnection component 2, in a possible implementation solution, the dielectric layer 21 may be made of an organic material. In this way, for the PCB 1 that uses the organic substrate, a material of the dielectric layer of the local interconnection component 2 has a similar thermal expansion capability to the base material of the PCB 1, to avoid mechanical stress caused by deformation of the dielectric layer and the PCB 1 at a joint after being heated. For example, but not limited to, the substrate of the PCB 1 may be a bismaleimide triazine (Bismaleimide Triazine, BT) resin plate, and the dielectric layer 21 may be made of PI, PP, or ABF.

In another possible implementation solution, the dielectric layer 21 may alternatively be made of an inorganic material, for example, but not limited to SiO₂. Certainly, in another possible implementation solution, the PCB 1 may be a circuit board in an inorganic system, and a substrate of the PCB 1 may be a ceramic sheet, a glass sheet, a metal plate, or the like. This is not limited in embodiments of this application.

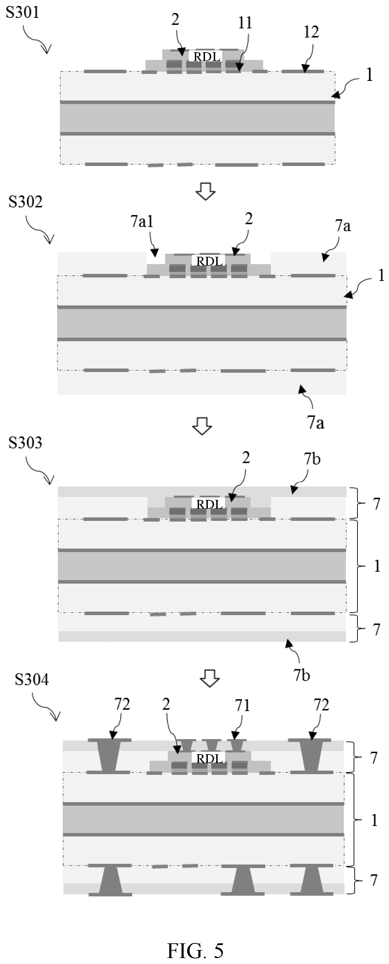

With reference to FIG. 5, the following briefly describes an assembly process of the local interconnection component 2 shown in FIG. 1.

Step S301: Mount the local interconnection component 2 on the board surface of the PCB 1.

For example, the local interconnection component 2 of the double-sided interconnection structure shown in the figure. The local interconnection component 2 may be bonded with the interconnection component interface pad 11 on the board surface of the PCB 1 by using a welding process, and the local interconnection component 2 is configured in a bridge buried area on the board surface of the PCB 1, to implement downward interconnection of the local interconnection component 2.

In specific implementation, after a flux cleaning operation is performed, an underfill process is used to protect a solder joint between the local interconnection component 2 and the PCB 1. Based on a structural feature that the local interconnection component 2 is directly disposed on the board surface of the PCB 1, it is convenient to perform cleaning and underfill operations. Therefore, mountability and reliability of the local interconnection component 2 being interconnected downward are effectively ensured.

Herein, the local interconnection component 2 may carry a carrier (carrier), and a carrier 3a of the local interconnection component 2 is removed after welding or adhesive fastening. This has good operability. Certainly, in another process, the local interconnection component 2 may alternatively not carry a carrier.

Step S302: Apply a first buildup layer 7a to the board surface of the PCB 1, where a window 7a1 is disposed at a position of a material of the first buildup layer 7a and a position of a corresponding local interconnection component 2, and the local interconnection component 2 is disposed in the window 7a1.

For example, but not limited to, a material of the first buildup layer 7a may be an ABF.

Step S303: Apply a second buildup layer 7b to the first buildup layer 7a, and form a buildup layer 7 after thermal compression bonding and leveling.

For example, but not limited to, a material of the second buildup layer 7b may be an ABF. It may be understood that, for a buildup layer that requires thermal compression bonding, the second buildup layer 7b preferably uses a same material as the first buildup layer 7a, to obtain better bonding strength.

In a thermal compression bonding process, after the material of the second buildup layer 7b is hot-melted, a gap between the local interconnection component 2 and the window 7a1 may be completely filled, thereby further improving assembly reliability of the local interconnection component 2.

It should be noted that, on another side board surface that is of the PCB 1 and that is away from the local interconnection component 2, a buildup layer 7 may also be disposed, for example, but not limited to, the process shown in step S302 and step S303 in FIG. 5, to interconnect with a corresponding functional device.

Step S304: Provide a hole on the buildup layer 7 and perform electroplating to form a stacked via, and form a first pad 71 and a second pad 72 at a corresponding position, to implement upward interconnection and leading out of the local interconnection component 2. In this way, the first pad 71 and the second pad 72 may be roughly located in a same plane. In other words, a mounting area of a die is a plane, so that the die can keep a stable posture in an assembly process.

In specific implementation, a process of providing a hole, electroplating, and surface pad may be implemented by using a conventional technology. This is not limited in this embodiment of this application.

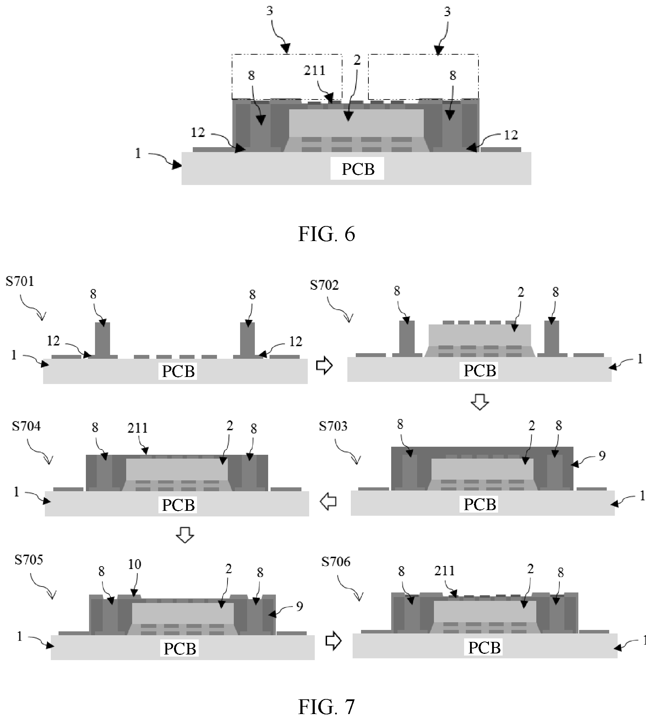

In the foregoing embodiment, reliability of die assembly is improved through buildup to the PCB. In another specific implementation, interconnection and mechanical support between the dies and the PCB may be further provided by disposing a pillar (Pillar). FIG. 6 is a diagram of another assembly relationship between a local interconnection component and a PCB according to an embodiment of this application.

As shown in FIG. 6, the local interconnection component 2 is disposed on the board surface of the PCB 1, a pillar 8 is disposed on the PCB 1 on a side of the local interconnection component 2, and an end face of the pillar 8 is flush with an interconnection pad 221 on a top surface of the local interconnection component 2. The "flush with" herein includes a case in which the end face of the pillar 8 is flush with the interconnection pad 221 of the local interconnection component 2 in an ideal state, and also includes a case in which tolerances are accumulated due to a limitation of process precision, provided that a requirement for reliable assembly of the dies can be met. That is, based on the pillar 8, a height difference between pads connected to bumps of the dies can be leveled, so that mounting areas of the dies are approximately on one plane.

As shown in the figure, at least two pillars 8 are respectively disposed on two sides of the local interconnection component 2, and are respectively connected to corresponding dies 3. In a possible implementation solution, a quantity of disposed pillars 8 may be determined according to a requirement, and may be disposed on a periphery of the local interconnection component 2 according to an overall design requirement of a product, instead of being limited to an arrangement form shown in FIG. 6.

To improve system integration, optionally, the pillar 8 may be a conductive pillar configured on a surface pad of the PCB 1, and has an electrical connection function on the basis of providing auxiliary mechanical support. The conductive pillar 8 may be made of a metal material, for example, but not limited to, a copper pillar. Alternatively, the conductive pillar 8 may be made of a non-metal material, and a surface of the pillar is plated with copper, so that the conductive pillar may also have both a support function and an electrical connection function.

For example, the pillar 8 may be a copper pillar electrically connected to the die interface pad 12 on the PCB 1, has relatively good conductivity, and may have a heat dissipation function based on a good heat conduction capability of the copper pillar, so that heat on a board side can be quickly exported. In this way, during assembling of the dies 3 on the board, two dies 3 to be connected are welded to the interconnection pad 221 on the first surface of the local interconnection component 2, and electrical interconnection is implemented through the high-density interconnection line layer of the local interconnection component 2. The dies 3 are also welded to the conductive pillar 8, to implement electrical interconnection between the dies 3 and the PCB.

With reference to FIG. 7, the following briefly describes an assembly process of the local interconnection component 2 shown in FIG. 6.

Step 701: Fabricate a copper pillar (the pillar 8) on the die interface pad 12 on the surface of the PCB 1.

In specific implementation, based on an incoming material of the PCB, the copper pillar may be formed through copper pillar planting or electroplating by using an existing process, and details are not described herein again.

Step 702: Mount the local interconnection component 2 on the board surface of the PCB 1.

For example, the local interconnection component 2 of the double-sided interconnection structure shown in the figure. The local interconnection component 2 may be configured in a bridge buried area of the PCB 1 by using a welding process, to implement downward interconnection of the local interconnection component 2.

In specific implementation, the interconnection component interface pad in the bridge buried area may be partially tinned, and the local interconnection component 2 is bonded with the interconnection component interface pad on the board surface of the PCB 1 by using a process such as welding. After a flux cleaning operation is performed, an underfill process may be used to protect a solder joint between the local interconnection component 2 and the PCB 1. Similarly, based on a structural feature that the local interconnection component 2 is directly disposed on the board surface of the PCB 1, it is convenient to perform flux cleaning and underfill operations. Therefore, reliability of the local interconnection component 2 being interconnected downward is effectively ensured.

In another possible implementation solution, when a conductive pillar 8 (for example, but not limited to a copper pillar) is disposed, flux cleaning may also be performed as a whole after all dies 3 are assembled, and then an underfill process is used to protect a solder joint between the local interconnection component 2 and the PCB 1 and a solder joint (not shown in the figure) between the dies 3 and the PCB 1.

Step 703: Perform plastic packaging on the local interconnection component 2 and the pillar 8 on the board surface of the PCB 1 to form a local plastic package body 9.

For example, but not limited to, an EMC (Epoxy Molding Compound, epoxy molding compound) may be used for plastic packaging.

Step 704: Remove a plastic package material on the top of the local interconnection component 2 and the pillar 8, that is, expose the conductive pillar 8 and the interconnection pad 221 of the local interconnection component 2. For example, but not limited to, a grinding process is used for implementation. This is not limited in embodiments of this application.

Step 705: Form a solder resist layer 10 on a surface of the plastic package body 9.

Step 706: Perform pad surface processing on the end face of the pillar 8 and the interconnection pad 221 of the local interconnection component 2, to obtain a good electrical conduction capability.

For example, but not limited to, the pad surface may be processed by using an ENIG (Electroless Nickel/Immersion Gold, electroless nickel/immersion gold) process, and may be specifically selected according to an actual process condition. This is not limited in embodiments of this application.

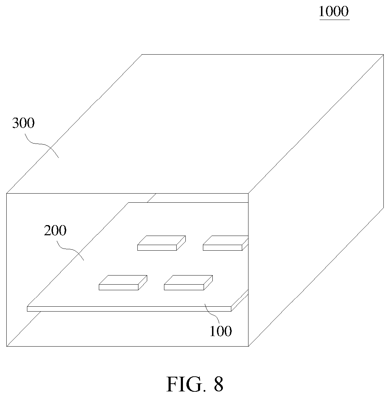

In addition to the foregoing chip packaging system, this implementation further provides an electronic device. FIG. 8 is a diagram of a structure of an electronic device according to an embodiment of this application.

As shown in FIG. 8, the electronic device 1000 includes a housing 300 and a mainboard 200 disposed in the housing 300. The mainboard 200 is provided with the chip on board system 100 described in the foregoing embodiment. Herein, the chip on board system 100 may be a functional component such as a CPU, a GPU, an ASIC, or an SOC.

In specific implementation, the electronic device may be a server, a computer, or a high-performance computing cluster, for example, a data center server having high power, high integration, and ultra-large scale. In addition, the electronic device may be a switch, a router, a building baseband unit, an edge device, or the like. This is not limited in this embodiment of this application.

It should be understood that other functions of the electronic device are not core inventive points of this application, and may be implemented by the person skilled in the art using the conventional technologies. Therefore, details are not described in this specification.

The foregoing are merely preferred implementations of the present invention. It should be noted that a person of ordinary skill in the art may make several improvements and modifications without departing from the principle of the present invention, and the improvements and modifications shall be regarded as falling within the protection scope of the present invention.

## Claims

1. A chip packaging system, wherein the chip packaging system comprises a PCB, a local interconnection component, and a plurality of dies, and the plurality of dies are electrically interconnected with the PCB separately; and
the local interconnection component is disposed on a board surface of the PCB, the local interconnection component comprises a dielectric layer and a high-density interconnection line layer that are stacked, and at least two of the dies are electrically interconnected by using the local interconnection component.

2. The chip packaging system according to claim 1, wherein the PCB further comprises a buildup layer, the buildup layer is disposed on a periphery of the local interconnection component, and interface pads electrically interconnected with the dies are disposed on a surface of the buildup layer.

3. The chip packaging system according to claim 2, wherein the local interconnection component comprises a first surface and a second surface, the first surface is disposed opposite to the PCB, and the second surface is disposed opposite to the dies; and
the interface pads comprise a first pad and a second pad, wherein the first pad is electrically connected to a pin on the first surface of the local interconnection component, and the second pad is electrically connected to a die interface pad on a surface layer of the PCB.

4. The chip packaging system according to claim 2 or 3, wherein the interface pads on the surface of the buildup layer are electrically connected to the local interconnection component and the PCB separately through a stacked via on the buildup layer.

5. The chip packaging system according to claim 1, wherein the PCB further comprises a pillar, the pillar is disposed on the PCB on a side of the local interconnection component, the pillar extends towards the dies connected to the local interconnection component, and an end face of the pillar is connected to the dies.

6. The chip packaging system according to claim 5, wherein the local interconnection component comprises a first surface and a second surface, the first surface is disposed opposite to the PCB, and the second surface is disposed opposite to the dies; and the end face of the pillar is flush with an interconnection pad on the first surface of the local interconnection component.

7. The chip packaging system according to claim 5 or 6, wherein the pillar is a conductive pillar, and the pillar is electrically connected to a die interface pad on the PCB, to establish electrical interconnection between the dies connected to the local interconnection component and the PCB.

8. The chip packaging system according to claim 7, wherein the pillar is a copper pillar.

9. The chip packaging system according to claim 7 or 8, wherein a solder joint between the dies and the PCB and a solder joint between the local interconnection component and the PCB are both covered through underfill.

10. The chip packaging system according to any one of claims 7 to 9, wherein the local interconnection component and the pillar are packaged in plastic to form a plastic package body located on the board surface of the PCB, and the end face of the pillar and the interconnection pad on the first surface of the local interconnection component are exposed from a surface of the plastic package body.

11. The chip packaging system according to any one of claims 1 to 10, wherein the local interconnection component is a double-sided interconnection structure, and a pin on the second surface of the local interconnection component is electrically connected to an interconnection component interface pad on the board surface of the PCB.

12. The chip packaging system according to any one of claims 1 to 11, wherein the local interconnection component is a single-sided interconnection structure, and the second surface of the local interconnection component is glued and fastened to the board surface of the PCB.

13. The chip packaging system according to any one of claims 1 to 12, wherein a plurality of local interconnection components are disposed, and the plurality of local interconnection components are arranged on the board surface of the PCB at intervals.

14. The chip packaging system according to any one of claims 1 to 13, wherein the dielectric layer is made of an organic material or an inorganic material.

15. The chip packaging system according to any one of claims 1 to 14, wherein a substrate of the PCB is a BT plate, a ceramic sheet, a glass sheet, or a metal plate.

16. The chip packaging system according to any one of claims 1 to 15, wherein the chip packaging system further comprises another functional device disposed on the PCB.

17. The chip packaging system according to claim 16, wherein the another functional device comprises at least one of a power supply module, a connector, and a capacitor.

18. The chip packaging system according to claim 16 or 17, wherein the another functional device and the dies are located on a same side board surface of the PCB, or the another functional device is located on the board surface that is of the PCB and that is opposite to the dies.

19. An electronic device, comprising a mainboard and the chip packaging system according to any one of claims 1 to 18, wherein the chip packaging system is disposed on the mainboard.
